(19) Europäisches Patentamt
European Patent Office
Office européen des brevets

(11) EP 4 607 576 A1

(12) EUROPEAN PATENT APPLICATION

(43) Date of publication:
27.08.2025 Bulletin 2025/35

(51) International Patent Classification (IPC):
H01L 21/66 (2006.01)

(21) Application number: 24158686.6

(22) Date of filing: 20.02.2024

(52) Cooperative Patent Classification (CPC):
H01L 22/12; G01N 23/20; G06N 20/20;
G01N 2223/6116; H01L 22/20

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(71) Applicant: ASML Netherlands B.V.
5500 AH Veldhoven (NL)

(72) Inventors:
• SOKOLOV, Sergei
5500 AH Veldhoven (NL)

• ROOS, Jan Corver
5500 AH Veldhoven (NL)
• WANG, Sheng
5500 AH Veldhoven (NL)
• BATISTAKIS, Chrysostomos
5500 AH Veldhoven (NL)
• VERMA, Alok
5500 AH Veldhoven (NL)

(74) Representative: ASML Netherlands B.V.
Corporate Intellectual Property
P.O. Box 324
5500 AH Veldhoven (NL)

(54) **MACHINE LEARNING ASSISTED PUPIL METROLOGY**

(57) Disclosed is a method of determining at least one bonding parameter of interest relating to a feature on a substrate comprising: obtaining angularly resolved metrology data relating to a measurement of said feature following illumination of said feature with a radiation beam and detecting radiation scattered by said feature at an angularly resolved plane; obtaining at least one trained model being operable to relate said angularly resolved metrology data to said bonding parameter of interest; and using the trained model to derive the bonding parameter of interest based on the angularly resolved metrology data.

Fig. 8

EP 4 607 576 A1

**Description**

FIELD

The present invention relates to a metrology apparatus and methods usable, for example, to perform metrology in the manufacture of devices by lithographic techniques. The invention further relates to such methods for determining a parameter of interest such as pad recess height in a lithographic process.

BACKGROUND

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g., including part of, one, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned.

In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field. These devices direct a beam of radiation onto a target and measure one or more properties of the scattered radiation - e.g., intensity at a single angle of reflection as a function of wavelength; intensity at one or more wavelengths as a function of reflected angle; or polarization as a function of reflected angle - to obtain a diffraction "spectrum" from which a property of interest of the target can be determined.

Examples of known scatterometers include angle-resolved scatterometers of the type described in US2006033921A1 and US2010201963A1. The targets used by such scatterometers are relatively large, e.g., 40$\mu$m by 40$\mu$m, gratings and the measurement beam generates a spot that is smaller than the grating (i.e., the grating is underfilled). Examples of dark field imaging metrology can be found in international patent applications US20100328655A1 and US2011069292A1 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

Advanced semiconductor packaging techniques such as 2.5D and 3D integration may rely on bonding methods such as wafer bonding, die to wafer bonding and die to die bonding, and may also rely on through silicon via technology (TSV). It is desirable to monitor parameters of interest during manufacturing to ensure that strict processing requirements are met. Such monitoring may be performed by typical profilometry methods such as atomic for microscopy (AFM), confocal microscopy and white light interferometry. In some cases, it may be time consuming to employ typical profilometry methods for monitoring parameters of interest which may affect throughput. In other cases, as parameters such as pitch and CD shrink towards the optical resolution of conventional profilometry systems, those methods may no longer be a suitable monitoring approach. Thus, it is desirable to provide enhanced methods to monitor parameters of interest.

SUMMARY

The invention in a first aspect provides a method of determining at least one bonding parameter of interest relating to a feature on a substrate comprising: obtaining angularly resolved metrology data relating to a measurement of said feature following illumination of said feature with a radiation beam and detecting radiation scattered by said feature at an angularly resolved plane; obtaining at least one trained model being operable to relate said angularly resolved metrology data to said bonding parameter of interest; and using the trained model to derive the bonding parameter of interest based on the angularly resolved metrology data.

BRIEF DESCRIPTION OF THE DRAWINGS

Embodiments of the invention will now be described, by way of example only, with reference to the accompanying schematic drawings in which corresponding reference symbols indicate corresponding parts, and in which:

Figure 1 depicts a lithographic apparatus;

Figure 2 depicts a lithographic cell or cluster in which an inspection apparatus according to the present invention may be used;

Figure 3(a) illustrates schematically inspection apparatus adapted to perform angle-resolved scatterometry and dark-field imaging inspection methods;

Figure 3(b) illustrates a target structure and diffracted rays of measurement radiation;

Figure 3(c) illustrates schematically a metrology apparatus suitable for the hard X-ray, soft X-rays and/or EUV domain;

Figure 4 illustrates schematically a scatterometer which may be used in some embodiments;

Figure 5 illustrates schematically a scatterometer which may be used in some embodiments;

Figure 6 depicts a first example process for reconstruction of a structure from scatterometer measurements;

Figure 7 depicts a second example process for reconstruction of a structure from scatterometer measurements;

Figure 8 is a schematic depiction of a hybrid bonding pad;

Figure 9 is a schematic depiction of a through silicon via;

Figure 10 depicts an example process for determining a parameter of interest in accordance with aspects of the present disclosure.

DETAILED DESCRIPTION

Before describing embodiments of the invention in detail, it is instructive to present an example environment in which embodiments of the present invention may be implemented.

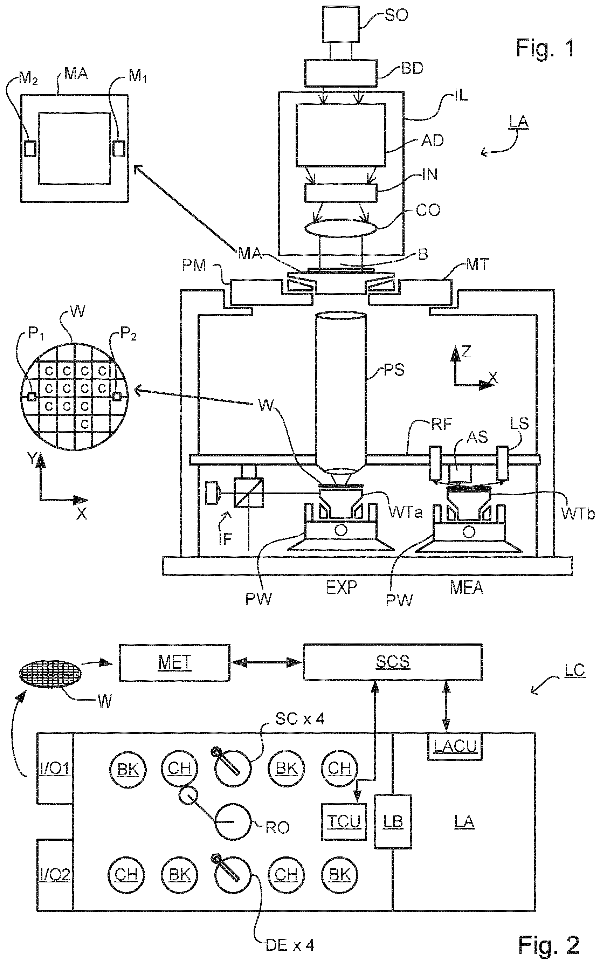

Figure 1 schematically depicts a lithographic apparatus LA. The apparatus includes an illumination system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; two substrate tables (e.g., a wafer table) WTa and WTb each constructed to hold a substrate (e.g., a resist coated wafer) W and each connected to a second positioner PW configured to accurately position the substrate in accordance with certain parameters; and a projection system (e.g., a refractive projection lens system) PS configured to project a pattern imparted to the radiation beam B by patterning device MA onto a target portion C (e.g., including one or more dies) of the substrate W. A reference frame RF connects the various components, and serves as a reference for setting and measuring positions of the patterning device and substrate and of features on them.

The illumination system may include various types of optical components, such as refractive, reflective, magnetic, electromagnetic, electrostatic or other types of optical components, or any combination thereof, for directing, shaping, or controlling radiation.

The patterning device support holds the patterning device in a manner that depends on the orientation of the patterning device, the design of the lithographic apparatus, and other conditions, such as for example whether or not the patterning device is held in a vacuum environment. The patterning device support can take many forms; the patterning device support may ensure that the patterning device is at a desired position, for example with respect to the projection system.

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

As here depicted, the apparatus is of a transmissive type (e.g., employing a transmissive patterning device). Alternatively, the apparatus may be of a reflective type (e.g., employing a programmable mirror array of a type as referred to above, or employing a reflective mask). Examples of patterning devices include masks, programmable mirror arrays, and programmable LCD panels. Any use of the terms "reticle" or "mask" herein may be considered synonymous with the more general term "patterning device." The term "patterning device" can also be interpreted as referring to a device storing in digital form pattern information for use in controlling such a programmable patterning device.

The term "projection system" used herein should be broadly interpreted as encompassing any type of projection system, including refractive, reflective, catadioptric, magnetic, electromagnetic and electrostatic optical systems, or any combination thereof, as appropriate for the exposure radiation being used, or for other factors such as the use of an immersion liquid or the use of a vacuum. Any use of the term "projection lens" herein may be considered as synonymous with the more general term "projection system".

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems.

In operation, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may for example include an adjuster AD for adjusting the angular intensity distribution of the radiation beam, an integrator IN and a condenser CO. The illuminator may be used to condition the radiation beam, to have a desired uniformity and intensity distribution in its cross section.

The radiation beam B is incident on the patterning device MA, which is held on the patterning device support MT, and is patterned by the patterning device. Having traversed the patterning device (e.g., mask) MA, the radiation beam B passes through the projection system PS, which focuses the beam onto a target portion C of the substrate W. With the aid of the second positioner PW and position sensor IF (e.g., an interferometric device, linear encoder, 2-D encoder or capacitive sensor), the substrate table WTa or WTb can be moved accurately, e.g., so as to position different target portions C in the path of the radiation beam B. Similarly, the first positioner PM and another position sensor (which is not explicitly depicted in Figure 1) can be used to accurately position the patterning device (e.g., reticle/mask) MA with respect to the path of the radiation beam B, e.g., after mechanical retrieval from a mask library, or during a scan.

Patterning device (e.g., reticle/mask) MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment mark may also be included within dies, in amongst the device features, in which case it is desirable that the markers be as small as possible and not require any different imaging or process conditions than adjacent features. The alignment system, which detects the alignment markers is described further below.

The depicted apparatus could be used in a variety of modes. In a scan mode, the patterning device support (e.g., mask table) MT and the substrate table WT are scanned synchronously while a pattern imparted to the radiation beam is projected onto a target portion C (i.e., a single dynamic exposure). The speed and direction of the substrate table WT relative to the patterning device support (e.g., mask table) MT may be determined by the (de-)magnification and image reversal characteristics of the projection system PS. In scan mode, the maximum size of the exposure field limits the width (in the non-scanning direction) of the target portion in a single dynamic exposure, whereas the length of the scanning motion determines the height (in the scanning direction) of the target portion. Other types of lithographic apparatus and modes of operation are possible, as is well-known in the art. For example, a step mode is known. In so-called "maskless" lithography, a programmable patterning device is held stationary but with a changing pattern, and the substrate table WT is moved or scanned.

Combinations and/or variations on the above described modes of use or entirely different modes of use may also be employed.

Lithographic apparatus LA is of a so-called dual stage type which has two substrate tables WTa, WTb and two stations - an exposure station EXP and a measurement station MEA - between which the substrate tables can be exchanged. While one substrate on one substrate table is being exposed at the exposure station, another substrate can be loaded onto the other substrate table at the measurement station and various preparatory steps carried out. This enables a substantial increase in the throughput of the apparatus. The preparatory steps may include mapping the surface height contours of the substrate using a level sensor LS and measuring the position of alignment markers on the substrate using an alignment sensor AS. If the position sensor IF is not capable of measuring the position of the substrate table while it is at the measurement station as well as at the exposure station, a second position sensor may be provided to enable the positions of the substrate table to be tracked at both stations, relative to reference frame RF. Other arrangements are known and usable instead of the dual-stage arrangement shown. For example, other lithographic apparatuses are known in which a substrate table and a measurement table are provided. These are docked together when performing preparatory measurements, and then undocked while the substrate table undergoes exposure.

As shown in Figure 2, the lithographic apparatus LA forms part of a lithographic cell LC, also sometimes referred to a lithocell or cluster, which also includes apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers then to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

In order that the substrates that are exposed by the lithographic apparatus are exposed correctly and consistently, it is desirable to inspect exposed substrates to measure properties such as overlay errors between subsequent layers, line thicknesses, critical dimensions (CD), etc. Accordingly a manufacturing facility in which lithocell LC is located also includes metrology system MET which receives some or all of the substrates W that have been processed in the lithocell. Metrology results are provided directly or indirectly to the supervisory control system SCS. If errors are detected, adjustments may be made to exposures of subsequent substrates, especially if the inspection can be done soon and fast enough that other substrates of the same batch are still to be exposed. Also, already exposed substrates may be stripped and reworked to improve yield, or discarded, thereby avoiding performing further processing on substrates that are known to be faulty. In a case where only some target portions of a substrate are faulty, further exposures can be performed only on those target portions which are good.

Within metrology system MET, an inspection apparatus is used to determine the properties of the substrates, and in particular, how the properties of different substrates or different layers of the same substrate vary from layer to layer. The inspection apparatus may be integrated into the lithographic apparatus LA or the lithocell LC or may be a stand-alone device. To enable most rapid measurements, it is desirable that the inspection apparatus measure properties in the exposed resist layer immediately after the exposure. However, the latent image in the resist has a very low contrast - there is only a very small difference in refractive index between the parts of the resist which have been exposed to radiation and those which have not - and not all inspection apparatus have sufficient sensitivity to make useful measurements of the latent image. Therefore measurements may be taken after the post-exposure bake step (PEB) which is customarily the first step carried out on exposed substrates and increases the contrast between exposed and unexposed parts of the resist. At this stage, the image in the resist may be referred to as semi-latent. It is also possible to make measurements of the developed resist image - at which point either the exposed or unexposed parts of the resist have been removed - or after a pattern transfer step such as etching. The latter possibility limits the possibilities for rework of faulty substrates but may still provide useful information.

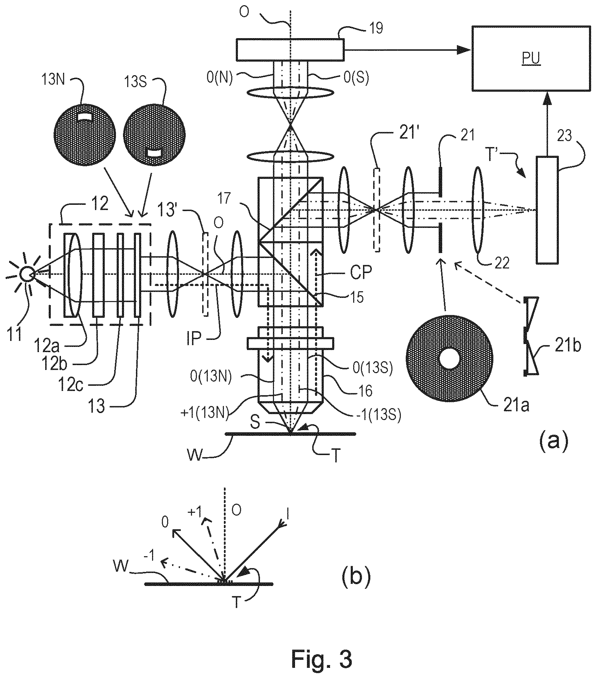

A metrology apparatus suitable for use in embodiments of the invention is shown in Figure 3(a). Note that this is only one example of a suitable metrology apparatus. An alternative suitable metrology apparatus may use EUV radiation such as, for example, that disclosed in WO2017/186483A1. A target structure T and diffracted rays of measurement radiation used to illuminate the target structure are illustrated in more detail in Figure 3(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 3(b), target structure T is placed with substrate W normal to the optical axis O of objective lens 16. The substrate W may be supported by a support (not shown). A ray of measurement radiation I impinging on target structure T from an angle off the axis O gives rise to a zeroth order ray (solid line 0) and two first order rays (dot-chain line +1 and double dot-chain line -1), hereafter referred to as a pair of complementary diffraction orders. It should be noted that the pair of complementary diffraction orders may be any higher order pair; e.g., the +2, -2 pair etc. and is not limited to the first order complementary pair. It should be remembered that with an overfilled small target structure, these rays are just one of many parallel rays covering the area of the substrate including metrology target structure T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the target structures and the illumination angles can be designed or adjusted so that the first order rays entering the objective lens are closely aligned with the central optical axis. The rays illustrated in Figure 3(a) and 3(b) are shown somewhat off axis, purely to enable them to be more easily distinguished in the diagram.

At least the 0 and +1 orders diffracted by the target structure T on substrate W are collected by objective lens 16 and directed back through beam splitter 15. Returning to Figure 3(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target structure on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target structure T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

Position errors may occur due to an overlay error (often referred to as "overlay"). The overlay is the error in placing a first feature during a first exposure relative to a second feature during a second exposure. The lithographic apparatus minimizes the overlay errors by aligning each substrate accurately to a reference prior to patterning. This is done by measuring positions of alignment marks on the substrate using an alignment sensor. More information on the alignment procedure can be found in U.S. Patent Application Publication No. US 2010-0214550, which is incorporated herein in its entirety by reference. Pattern dimensioning (e.g., CD) errors may, for example, occur when the substrate is not positioned correctly with respect to a focal plane of the lithographic apparatus. These focal position errors may be associated with un-flatness of a substrate surface. The lithographic apparatus aims to minimize these focal position errors by measuring the substrate surface topography prior to patterning using a level sensor. Substrate height corrections are applied during subsequent patterning to help assure correct imaging (focusing) of the patterning device onto the substrate. More information on the level sensor system can be found in U.S. Patent Application Publication No. US 2007-0085991, which is incorporated herein in its entirety by reference.

Besides the lithographic apparatus LA and the metrology apparatus MT, one or more other processing apparatuses may be used during device production as well. An etching station (not shown) processes the substrates after exposure of the pattern into the resist. The etch station transfers the pattern from the resist into one or more layers underlying the resist layer. Typically etching is based on application of a plasma medium. One or more local etching characteristics may e.g. be controlled using temperature control of the substrate or directing the plasma medium using a voltage controlled ring. More information on etching control can be found in PCT Patent Application Publication No. WO 2011-081645 and U.S. Patent Application Publication No. US 2006-016561, which are incorporated herein in their entireties by reference.

During the manufacturing of devices, it is desired that the process conditions for processing substrates using one or more processing apparatuses such as the lithographic apparatus or etching station remain stable such that properties of the features remain within certain control limits. Stability of the process is of particular significance for features of the functional parts of an electric device such as an IC, also referred to as product features. To help ensure stable processing, process control capabilities should be in place. Process control involves monitoring of processing data and implementation of means for process correction, e.g. control a processing apparatus based on one or more characteristics of the processing data. Process control may be based on periodic measurement by the metrology apparatus MT, often referred to as "Advanced Process Control" (further also referenced to as APC). More information on APC can be found in U.S. Patent Application Publication No. US 2012-008127, which is incorporated herein in its entirety by reference. A typical APC implementation involves periodic measurements on metrology features on the substrates to monitor and correct drifts associated with one or more processing apparatuses. The metrology features reflect the response to process variations of the product features. The sensitivity of the metrology features to process variations may be different compared to the sensitivity to the product features. In that case, a so-called "Metrology To Device" offset (also referenced to as MTD) may be determined.

One reason for this is MTD offset is that the actual product structures are often much (orders of magnitude) smaller than the size of the target structures which are required for scatterometry or imaging measurements, and this difference in size can result in different parameter behavior (e.g., pattern placement and resulting overlay for metrology targets may differ from pattern placement and resulting overlay of actual structures). To mimic the behavior of product features, features within the metrology targets may be made smaller (e.g., of comparable size to the product structures, which can be referred to as at-resolution overlay ARO), incorporate segmented features, assist features or features with a particular geometry and/or dimension. A carefully designed metrology target ideally should respond in a similar fashion to process variations as do the product features. More information on metrology target design can be found in PCT Patent Application Publication No. WO 2015-101458 which is incorporated herein in its entirety by reference.

In another approach, metrology may be performed directly on the product structure. This can be done using a scanning electron microscope (SEM) or an e-beam metrology apparatus for example. However, these devices are typically too slow for process control in a commercial (high-volume manufacturing HVM) environment. A known metrology technique is known as in-device metrology (IDM). In IDM, a wafer is measured (e.g., after-etch) using, for example, a metrology tool such as illustrated in Figure 3(a) (using the pupil imaging branch). The resulting optical signals, typically referred to herein as "pupils", each comprise an angularly resolved spectrum of measured values or signal parameter values (e.g., intensities, diffraction efficiencies or any other suitable parameter). These pupils are obtained from radiation scattered from a "target" on the substrate, and may comprise radiation from any one or more diffraction orders, where a diffraction order in this context includes the zeroth order (specularly reflected radiation). As such, a pupil may be obtained from only the zeroth order, only a single higher order or a combination of orders.

In an embodiment, a pupil of the scattered radiation is measured, i.e., at a Fourier transform plane. The term pupil and pupil plane herein includes any conjugates thereof unless the context otherwise requires (for example, where a pupil plane of a particular optical system is being identified).

The target may be a metrology target formed specifically for the purposes of metrology (e.g., a grating). Such a grating may, in some embodiments, mimic device structure such as logic structure (e.g., a regularized version of the product structure). Alternatively, the term "target" in the context of this disclosure may also include actual functional product structure, e.g., where it is sufficiently periodic or regular to perform metrology directly thereon. In some cases, the target may be a recess, for example a hybrid bonding pad recess.

By decreasing the wavelength of the radiation used during metrology it is possible to resolve smaller structures, to increase sensitivity to structural variations of the structures and/or penetrate further into the product structures. One such method of generating suitably high frequency radiation (e.g. hard X-ray, soft X-ray and/or EUV radiation) may be using a pump radiation (e.g., infrared IR radiation) to excite a generating medium, thereby generating an emitted radiation, optionally a high harmonic generation comprising high frequency radiation.

Thus, as an alternative to optical metrology methods, it has also been considered to use hard X-ray, soft X-rays or EUV radiation, for example radiation with at least one of the wavelength ranges: <0.01nm, <0.1nm, <1nm, between 0.01nm and 100nm, between 0.01nm and 50nm, between 1nm and 50nm, between 1nm and 20nm, between 5nm and 20nm, and between 10nm and 20nm. One example of metrology tool functioning in one of the above presented wavelength ranges is transmissive small angle X-ray scattering (T-SAXS as in US 2007224518A which content is incorporated herein by reference in its entirety). Profile (CD) measurements using T-SAXS are discussed by Lemaillet et al in "Intercomparison between optical and X-ray scatterometry measurements of FinFET structures", Proc. of SPIE, 2013, 8681. It is noted that the use of laser produced plasma (LPP) x-ray source is described in U.S. Patent Publication No. 2019 /003988A1, and in U.S. Patent Publication No. 2019 /215940A1, which are incorporated herein by reference in the entirety. Reflectometry techniques using X-rays (GI-XRS) and extreme ultraviolet (EUV) radiation at grazing incidence may be used for measuring properties of films and stacks of layers on a substrate. Within the general field of reflectometry, goniometric and/or spectroscopic techniques may be applied. In goniometry, the variation of a reflected beam with different incidence angles may be measured. Spectroscopic reflectometry, on the other hand, measures the spectrum of wavelengths reflected at a given angle (using broadband radiation). For example, EUV reflectometry has been used for inspection of mask blanks, prior to manufacture of reticles (patterning devices) for use in EUV lithography.

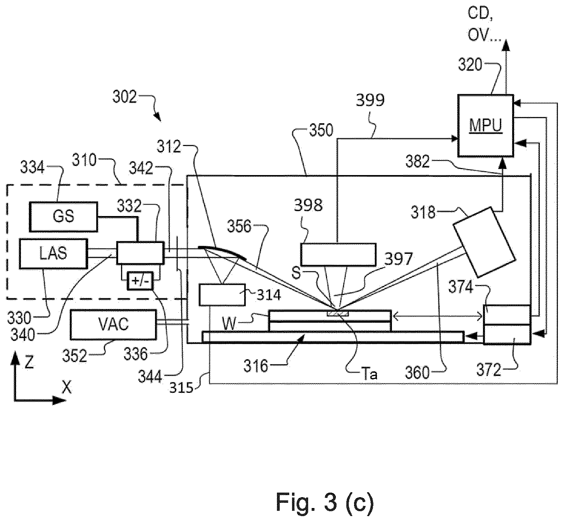

Figure 3(c) depicts a schematic representation of a metrology apparatus 302 in which the aforementioned radiation may be used to measure parameters of structures on a substrate. The metrology apparatus 302 presented in Figure 3(c) may be suitable for the hard X-ray, soft X-rays and/or EUV domain.

Figure 3(c) illustrates a schematic physical arrangement of a metrology apparatus 302 comprising a spectroscopic scatterometer using hard X-ray, Soft X-Ray and/or EUV radiation optionally in grazing incidence, purely by way of example. An alternative form of inspection apparatus might be provided in the form of an angle-resolved scatterometer, which may use radiation in normal or near-normal incidence similar to the conventional scatterometers operating at longer wavelengths, and which may also use radiation with direction being greater than 1° or 2° from a direction parallel to the substrate. An alternative form of inspection apparatus might be provided in the form of a transmissive scatterometer.

Inspection apparatus 302 comprises a radiation source or called illumination source 310, illumination system 312, substrate support 316, detection systems 318, 398 and metrology processing unit (MPU) 320.

An illumination source 310 in this example is for a generation of EUV, hard X-ray or soft X-ray radiation. The illumination source 310 may be based on high harmonic generation (HHG) techniques as shown in Figure 3(c), and it may also be other types of illumination sources, e.g. liquid metal jet source, inverse Compton scattering (ICS) source, plasma channel source, magnetic undulator source, free electron laser (FEL) source, compact storage ring source, electrical discharge produced plasma source, soft X-ray laser source, rotating anode source, solid anode source, particle accelerator source, microfocus source, or laser produced plasma source.

The HHG source may be a gas jet/nozzle source, a capillary/fiber source or a gas cell source.

For the example of HHG source, as shown in Figure 3(c), main components of the radiation source are a pump radiation source 330 operable to emit the pump radiation and a gas delivery system 332. Optionally the pump radiation source 330 is a laser, optionally the pump radiation source 330 is a pulsed high-power infrared or optical laser. The pump radiation source 330 may be, for example, a fiber-based laser with an optical amplifier, producing pulses of infrared radiation that may last for example less than 1 ns (1 nanosecond) per pulse, with a pulse repetition rate up to several megahertz, as required. The wavelength of the infrared radiation may be in the range 200nm to 10$\mu$m, for example in the region of 1 $\mu$m (1 micron). Optionally, the laser pulses are delivered as a first pump radiation 340 to the gas delivery system 332, wherein the gas a portion of the radiation is converted to higher frequencies than the first radiation into an emitted radiation 342. A gas supply 334 supplies a suitable gas to the gas delivery system 332, where it is optionally ionized by an electric source 336. The gas delivery system 332 may be a cut tube.

A gas provided by the gas delivery system 332 defines a gas target, which may be a gas flow or a static volume. The gas may be for example air, Neon (Ne), Helium (He), Nitrogen (N2), Oxygen (02), Argon (Ar), Krypton (Kr), Xenon (Xe), Carbon dioxide and the combination of them. These may be selectable options within the same apparatus. The emitted radiation may contain multiple wavelengths. If the emitted radiation were monochromatic, then measurement calculations (for example reconstruction) may be simplified, but it is easier to produce radiation with several wavelengths. An emission divergence angle of the emitted radiation may be wavelength dependent. Different wavelengths will, for example, provide different levels of contrast when imaging structure of different materials. For inspection of metal structures or silicon structures, for example, different wavelengths may be selected to those used for imaging features of (carbon-based) resist, or for detecting contamination of such different materials. One or more filtering devices 344 may be provided. For example a filter such as a thin membrane of Aluminum (Al) or Zirconium (Zr) may serve to cut the fundamental IR radiation from passing further into the inspection apparatus. A grating (not shown) may be provided to select one or more specific wavelengths from among those generated. Optionally the illumination source comprises a space that is configured to be evacuated and the gas delivery system is configured to provide a gas target in the space. Optionally some or all of the beam path may be contained within a vacuum environment, bearing in mind that SXR and/or EUV radiation is absorbed when traveling in air. The various components of radiation source 310 and illumination optics 312 may be adjustable to implement different metrology 'recipes' within the same apparatus. For example different wavelengths and/or polarization may be made selectable.

Depending on the materials of the structure under inspection, different wavelengths may offer a desired level of penetration into lower layers. For resolving the smallest device features and defects among the smallest device features, then a short wavelength is likely to be preferred. For example, one or more wavelengths in the range 0.01-20 nm or optionally in the range 1-10 nm or optionally in the range 10-20 nm may be chosen. Wavelengths shorter than 5 nm may suffer from very low critical angle when reflecting off materials of interest in semiconductor manufacture. Therefore to choose a wavelength greater than 5 nm may provide stronger signals at higher angles of incidence. On the other hand, if the inspection task is for detecting the presence of a certain material, for example to detect contamination, then wavelengths up to 50 nm could be useful.

From the radiation source 310, the filtered beam 342 may enter an inspection chamber 350 where the substrate W including a structure of interest is held for inspection at a measurement position by substrate support 316. The structure of interest is labeled T. Optionally the atmosphere within inspection chamber 350 may be maintained near vacuum by vacuum pump 352, so that SXR and/or EUV radiation may pass with-out undue attenuation through the atmosphere. The Illumination system 312 has the function of focusing the radiation into a focused beam 356, and may comprise for example a two-dimensionally curved mirror, or a series of one-dimensionally curved mirrors, as described in published US patent application US2017/0184981A1 (which content is incorporated herein by reference in its entirety), mentioned above. The focusing is performed to achieve a round or elliptical spot S under 10 $\mu$m in diameter, when projected onto the structure of interest. Substrate support 316 comprises for example an X-Y translation stage and a rotation stage, by which any part of the substrate W may be brought to the focal point of beam to in a desired orientation. Thus the radiation spot S is formed on the structure of interest. Alternatively, or additionally, substrate support 316 comprises for example a tilting stage that may tilt the substrate W at a certain angle to control the angle of incidence of the focused beam on the structure of interest T.

Optionally, the illumination system 312 provides a reference beam of radiation to a reference detector 314 which may be configured to measure a spectrum and/or intensities of different wavelengths in the filtered beam 342. The reference detector 314 may be configured to generate a signal 315 that is provided to processor 320 and the filter may comprise information about the spectrum of the filtered beam 342 and/or the intensities of the different wavelengths in the filtered beam.

Reflected radiation 360 is captured by detector 318 and a spectrum is provided to processor 320 for use in calculating a property of the target structure T. The illumination system 312 and detection system 318 thus form an inspection apparatus. This inspection apparatus may comprise a hard X-ray, soft X-ray and/or EUV spectroscopic reflectometer of the kind described in US2016282282A1 which content is incorporated herein by reference in its entirety.

If the target Ta has a certain periodicity, the radiation of the focused beam 356 may be partially diffracted as well. The diffracted radiation 397 follows another path at well-defined angles with respect to the angle of incidence then the reflected radiation 360. In Figure 3(c), the drawn diffracted radiation 397 is drawn in a schematic manner and diffracted radiation 397 may follow many other paths than the drawn paths. The inspection apparatus 302 may also comprise further detection systems 398 that detect and/or image at least a portion of the diffracted radiation 397. In Figure 3(c) a single further detection system 398 is drawn, but embodiments of the inspection apparatus 302 may also comprise more than one further detection system 398 that are arranged at different position to detect and/or image diffracted radiation 397 at a plurality of diffraction directions. In other words, the (higher) diffraction orders of the focused radiation beam that impinges on the target Ta are detected and/or imaged by one or more further detection systems 398. The one or more detection systems 398 generates a signal 399 that is provided to the metrology processor 320. The signal 399 may include information of the diffracted light 397 and/or may include images obtained from the diffracted light 397.

To aid the alignment and focusing of the spot S with desired product structures, inspection apparatus 302 may also provide auxiliary optics using auxiliary radiation under control of metrology processor 320. Metrology processor 320 may also communicate with a position controller 372 which operates the translation stage, rotation and/or tilting stages. Processor 320 receives highly accurate feedback on the position and orientation of the substrate, via sensors. Sensors 374 may include interferometers, for example, which may give accuracy in the region of picometers. In the operation of the inspection apparatus 302, spectrum data 382 captured by detection system 318 is delivered to metrology processing unit 320.

As mentioned an alternative form of inspection apparatus uses hard X-ray, soft X-ray and/or EUV radiation optionally at normal incidence or near-normal incidence, for example to perform diffraction-based measurements of asymmetry. Another alternative form of inspection apparatus uses hard X-ray, soft X-ray and/or EUV radiation with direction being greater than 1° or 2° from a direction parallel to the substrate. Both types of inspection apparatus could be provided in a hybrid metrology system. Performance parameters to be measured may include overlay (OVL), critical dimension (CD), focus of the lithography apparatus while the lithography apparatus printed the target structure, coherent diffraction imaging (CDI) and at-resolution overlay (ARO) metrology. The hard X-ray, soft X-ray and/or EUV radiation may for example have wavelengths less than 100 nm, for example using radiation in the range 5-30 nm, of optionally in the range from 10 nm to 20 nm. The radiation may be narrowband or broadband in character. The radiation may have discrete peaks in a specific wavelength band or may have a more continuous character.

A metrology signal in the context of this disclosure may comprise a raw pupil image or a processed pupil image. A processed pupil image may comprise a pupil image data in any form, including for example, one or more of: representation as a vector or matrix (e.g., of intensities, diffraction efficiencies or any other suitable parameter values) and/or having undergone any other processing techniques such as dimensionality reduction.

The metrology described herein may further comprise CD reconstruction. CD reconstruction belongs to a group of problems known under the general name of inverse scattering, in which observed data is matched to a possible physical situation. The aim is to find a physical situation that gives rise to the observed data as closely as possible. In the case of scatterometry, the electromagnetic theory (Maxwell's equations) allows one to predict what will be the measured (scattered) data for a given physical situation. This is called the forward scattering problem. The inverse scattering problem is now to find the proper physical situation that corresponds to the actual measured data, which is typically a highly nonlinear problem. To solve this inverse scattering problem, a nonlinear solver is used that uses the solutions of many forward scattering problems. In known approaches for reconstruction, the nonlinear problem is founded on three ingredients:

- Gauss-Newton minimization of the difference between measured data and data computed from the estimated scattering setup;
- parameterized shapes in the scattering setup, e.g. radius and height of a contact hole;
- sufficiently high accuracy in the solution of the forward problem (e.g. computed reflection coefficients) each time the parameters are updated.

For CD reconstruction of 1D- or 2D-periodic structures (e.g. gratings) a Volume Integral Method (VIM) can be used to efficiently compute the solution of the pertaining scattering problem, as has been disclosed in US patent application publication no. US2011/0218789 A1 and US patent application publication no. US2011/0098992 A1, which are incorporated herein by reference. The particular choice for a spectral expansion in the plane of periodicity, results in a fully decoupled modal description in the orthogonal aperiodic direction. This modal description, which takes the form of a sequence of 1-dimensional integral equations, each with a 1D Green's function that describes the wave propagation per mode, is discretized or sampled to arrive at a numerical scheme. For a low-order discretization scheme, the structure of the 1D integral equations leads to a numerically stable and efficient $O(N)$ algorithm for the matrix-vector product, where N is the number of samples per 1D integral equation.

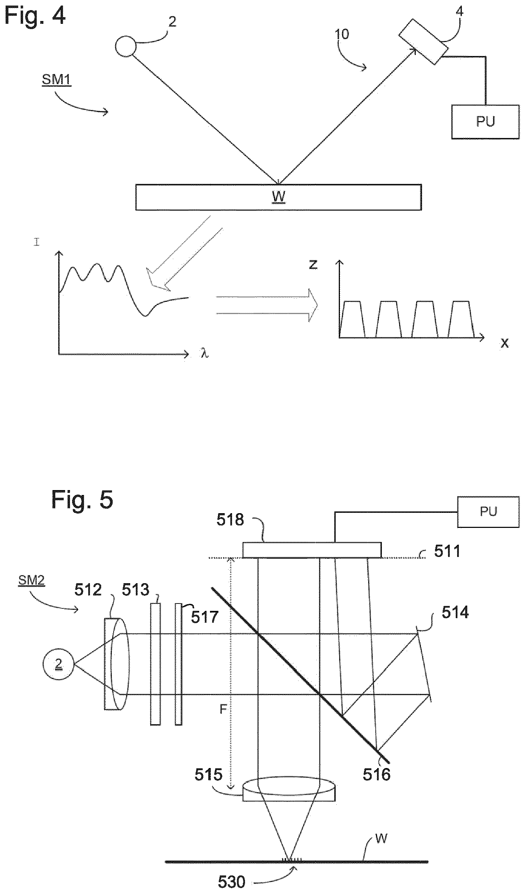

Figure 4 depicts a scatterometer which may be used in an embodiment of the present invention. It comprises a broadband (white light) radiation projector 2 which projects radiation onto a substrate W. The reflected radiation is passed to a spectrometer detector 4, which measures a spectrum 10 (intensity as a function of wavelength) of the specular reflected radiation. From this data, the structure or profile giving rise to the detected spectrum may be reconstructed by processing unit PU, e.g., conventionally by Rigorous Coupled Wave Analysis (RCWA) and non-linear regression or by comparison with a library of simulated spectra as shown at the bottom of Figure 4. In general, for the reconstruction the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

Another scatterometer that may be used in an embodiment of the present invention is shown in Figure 5. In this device, the radiation emitted by radiation source 2 is focused using lens system 512 through interference filter 513 and polarizer 517, reflected by partially reflective surface 516 and is focused onto substrate W via a microscope objective lens 515, which has a high numerical aperture (NA), preferably at least 0.9 and more preferably at least 0.95. Immersion scatterometers may even have lenses with numerical apertures over 1. The reflected radiation then transmits through partially reflective surface 516 into a detector 518 in order to have the scatter spectrum detected. The detector may be located in the back-projected pupil plane 511, which is at the focal length of the lens system 515, however the pupil plane may instead be re-imaged with auxiliary optics (not shown) onto the detector. The pupil plane is the plane in which the radial position of radiation defines the angle of incidence and the angular position defines azimuth angle of the radiation. The detector is preferably a two-dimensional detector so that a two-dimensional angular scatter spectrum of a substrate target 530 can be measured. The detector 518 may be, for example, an array of CCD or CMOS sensors, and may use an integration time of, for example, 40 milliseconds per frame.

As described above, the target is on the surface of the substrate. This target will often take the shape of a series of lines in a grating or substantially rectangular structures in a 2-D array. The purpose of rigorous optical diffraction theories in metrology is effectively the calculation of a diffraction spectrum that is reflected from the target. In other words, target shape information is obtained for CD (critical dimension) uniformity and overlay metrology. Overlay metrology is a measuring system in which the overlay of two targets is measured in order to determine whether two layers on a substrate are aligned or not. CD uniformity is simply a measurement of the uniformity of the grating on the spectrum to determine how the exposure system of the lithographic apparatus is functioning. Specifically, CD, or critical dimension, is the width of the object that is "written" on the substrate and is the limit at which a lithographic apparatus is physically able to write on a substrate.

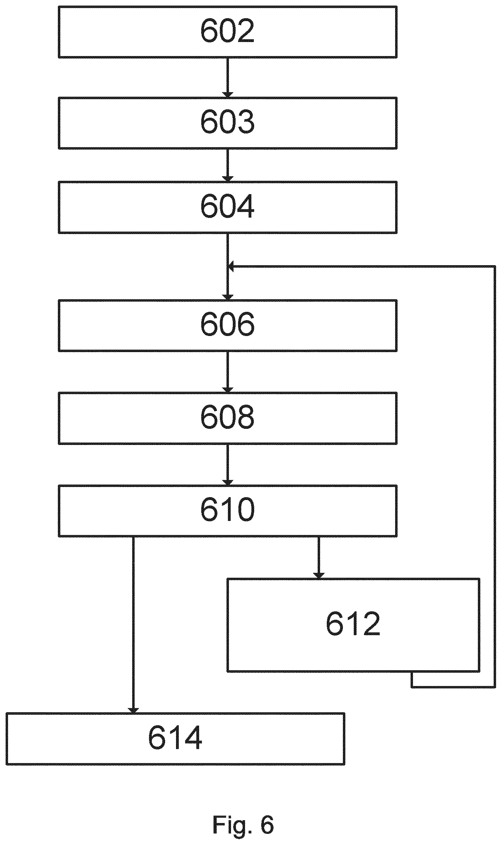

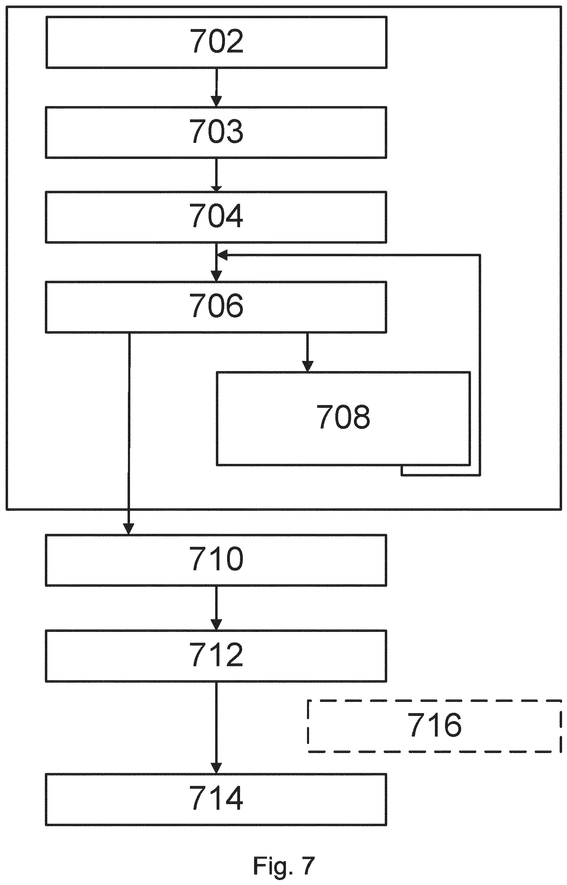

Using one of the scatterometers described above in combination with modeling of a target structure such as the target 530 and its diffraction properties, measurement of the shape and other parameters of the structure can be performed in a number of ways. In a first type of process, represented by Figure 6, a diffraction pattern based on a first estimate of the target shape (a first candidate structure) is calculated and compared with the observed diffraction pattern. Parameters of the model are then varied systematically and the diffraction re-calculated in a series of iterations, to generate new candidate structures and so arrive at a best fit. In a second type of process, represented by Figure 7, diffraction spectra for many different candidate structures are calculated in advance to create a 'library' of diffraction spectra. Then the diffraction pattern observed from the measurement target is compared with the library of calculated spectra to find a best fit. Both methods can be used together: a coarse fit can be obtained from a library, followed by an iterative process to find a best fit.

Referring to Figure 6 in more detail, the way the measurement of the target shape and/or material properties is carried out will be described in summary. The target will be assumed for this description to be a 1-dimensional (1-D) structure. In practice it may be 2-dimensional, and the processing will be adapted accordingly.

In step 602, the diffraction pattern of the actual target on the substrate is measured using a scatterometer such as those described above. This measured diffraction pattern is forwarded to a calculation system such as a computer. The calculation system may be the processing unit PU referred to above, or it may be a separate apparatus.

In step 603, a 'model recipe' is established which defines a parameterized model of the target structure in terms of a number of parameters $p_i$ ($p_1$, $p_2$, $p_3$ and so on). These parameters may represent for example, in a 1D periodic structure, the angle of a side wall, the height or depth of a feature, the width of the feature. Properties of the target material and underlying layers are also represented by parameters such as refractive index (at a particular wavelength present in the scatterometry radiation beam). Specific examples will be given below. Importantly, while a target structure may be defined by dozens of parameters describing its shape and material properties, the model recipe will define many of these to have fixed values, while others are to be variable or 'floating' parameters for the purpose of the following process steps. Further below we describe the process by which the choice between fixed and floating parameters is made. Moreover, we shall introduce ways in which parameters can be permitted to vary without being fully independent floating parameters. For the purposes of describing Figure 5, only the variable parameters are considered as parameters $p_i$.

In step 604: A model target shape is estimated by setting initial values $p_i(0)$ for the floating parameters (i.e. $p_1(0)$, $p_2(0)$, $p_3(0)$ and so on). Each floating parameter will be generated within certain predetermined ranges, as defined in the recipe.

In step 606, the parameters representing the estimated shape, together with the optical properties of the different elements of the model, are used to calculate the scattering properties, for example using a rigorous optical diffraction method such as RCWA or any other solver of Maxwell equations. This gives an estimated or model diffraction pattern of the estimated target shape.

In steps 608 and 610, the measured diffraction pattern and the model diffraction pattern are then compared and their similarities and differences are used to calculate a "merit function" for the model target shape.

In step 612, assuming that the merit function indicates that the model needs to be improved before it represents accurately the actual target shape, new parameters p1(1), p2(1), p3(1), etc. are estimated and fed back iteratively into step 606. Steps 606-612 are repeated.

In order to assist the search, the calculations in step 606 may further generate partial derivatives of the merit function, indicating the sensitivity with which increasing or decreasing a parameter will increase or decrease the merit function, in this particular region in the parameter space. The calculation of merit functions and the use of derivatives is generally known in the art, and will not be described here in detail.

In step 614, when the merit function indicates that this iterative process has converged on a solution with a desired accuracy, the currently estimated parameters are reported as the measurement of the actual target structure.

The computation time of this iterative process is largely determined by the forward diffraction model used, i.e. the calculation of the estimated model diffraction pattern using a rigorous optical diffraction theory from the estimated target structure. If more parameters are required, then there are more degrees of freedom. The calculation time increases in principle with the power of the number of degrees of freedom.

The estimated or model diffraction pattern calculated at 606 can be expressed in various forms. Comparisons are simplified if the calculated pattern is expressed in the same form as the measured pattern generated in step 610. For example, a modeled spectrum can be compared easily with a spectrum measured by the apparatus of Figure 4; a modeled pupil pattern can be compared easily with a pupil pattern measured by the apparatus of Figure 5.

Throughout this description from Figure 6 onward, the term 'diffraction pattern' will be used, on the assumption that the scatterometer of Figure 5 is used. The skilled person can readily adapt the teaching to different types of scatterometer, or even other types of measurement instrument.

Figure 7 illustrates an alternative example process in which plurality of model diffraction patterns for different estimated target shapes (candidate structures) are calculated in advance and stored in a library for comparison with a real measurement. The underlying principles and terminology are the same as for the process of Figure 6. The steps of the Figure 7 process are:

In step 702, the process of generating the library is performed. A separate library may be generated for each type of target structure. The library may be generated by a user of the measurement apparatus according to need, or may be pre-generated by a supplier of the apparatus.

In step 703, a 'model recipe' is established which defines a parameterized model of the target structure in terms of a number of parameters pi (p1, p2, p3 and so on). Considerations are similar to those in step 703 of the iterative process.

In step 704, a first set of parameters p1(0), p2(0), p3(0), etc. is generated, for example by generating random values of all the parameters, each within its expected range of values.

In step 706, a model diffraction pattern is calculated and stored in a library, representing the diffraction pattern expected from a target shape represented by the parameters.

In step 708, a new set of parameters p1(1), p2(1), p3(1), etc. is generated. Steps 706-708 are repeated tens, hundreds or even thousands of times, until the library which comprises all the stored modeled diffraction patterns is judged sufficiently complete. Each stored pattern represents a sample point in the multi-dimensional parameter space. The samples in the library should populate the sample space with a sufficient density that any real diffraction pattern will be sufficiently closely represented.

In step 710, after the library is generated (though it could be before), the real target 30 is placed in the scatterometer and its diffraction pattern is measured.

In step 712, the measured pattern is compared with the modeled patterns stored in the library to find the best matching pattern. The comparison may be made with every sample in the library, or a more systematic searching strategy may be employed, to reduce computational burden.

In step 714, if a match is found then the estimated target shape used to generate the matching library pattern can be determined to be the approximate object structure. The shape parameters corresponding to the matching sample are output as the measured shape parameters. The matching process may be performed directly on the model diffraction signals, or it may be performed on substitute models which are optimized for fast evaluation.

In step 716, optionally, the nearest matching sample is used as a starting point, and a refinement process is used to obtain the final parameters for reporting. This refinement process may comprise an iterative process very similar to that shown in Figure 5, for example.

Whether refining step 716 is needed or not is a matter of choice for the implementer. If the library is very densely sampled, then iterative refinement may not be needed because a good match will always be found. On the other hand, such a library might be too large for practical use. A practical solution is thus to use a library search for a coarse set of parameters, followed by one or more iterations using the merit function to determine a more accurate set of parameters to report the parameters of the target substrate with a desired accuracy. Where additional iterations are performed, it would be an option to add the calculated diffraction patterns and associated refined parameter sets as new entries in the library. In this way, a library can be used initially which is based on a relatively small amount of computational effort, but which builds into a larger library using the computational effort of the refining step 716. Whichever scheme is used, a further refinement of the value of one or more of the reported variable parameters can also be obtained based upon the goodness of the matches of multiple candidate structures. For example, the parameter values finally reported may be produced by interpolating between parameter values of two or more candidate structures, assuming both or all of those candidate structures have a high matching score.

The computation time of this iterative process is largely determined by the forward diffraction model at steps 606 and 706, i.e. the calculation of the estimated model diffraction pattern using a rigorous optical diffraction theory from the estimated target shape.

For CD reconstruction of 2D-periodic structures RCWA is commonly used in the forward diffraction model, while the Differential Method, the Volume Integral Method (VIM), Finite-difference time-domain (FDTD), and Finite element method (FEM) have also been reported. A Fourier series expansion as for example used in RCWA and the Differential Method can also be used to analyze aperiodic structures by employing perfectly matched layers (PMLs), or other types of absorbing boundary conditions to mimic radiation towards infinity, near the boundary of the unit cell on which the Fourier expansions are used.

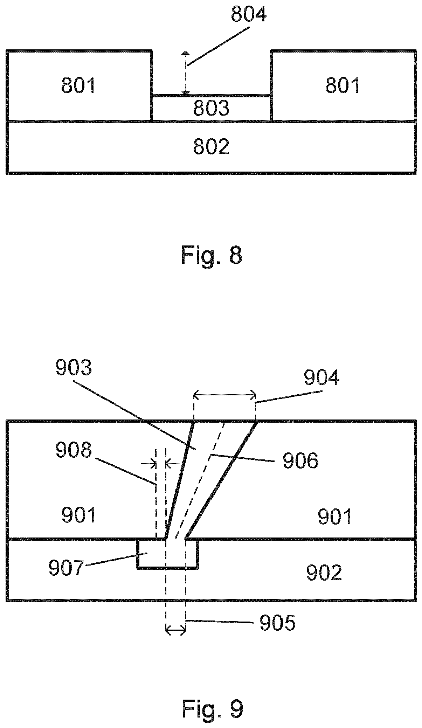

2.5D and 3D integration are known advanced semiconductor packaging techniques. For example, 2.5D integration comprises placing semiconductor dies side by side on an interposer, and 3D integration comprises vertically stacking dies. Such packaging techniques may be used to reduce interconnects, increase interconnect density, decrease device complexity and improve device performance. 2.5D/3D integration may use bonding methods such as wafer bonding, die to wafer bonding, and wafer to wafer bonding to obtain a bonded stack. Traditionally, bonding is carried out using bumps (i.e., raised areas of metal on corresponding parts of the surfaces to be bonded) of metal having a pitch of, for example, around 10$\mu$m. A recent advancement in bonding technology is the emergence of hybrid bonding. With reference to Figure 8, hybrid bonding uses bonding pads 803 (e.g., comprising any suitable metal such as copper) having a pitch of less than 10$\mu$m which are recessed with respect to a level of a surrounding dielectric 801 (e.g., an oxide or any other suitable dielectric) located on a substrate 802.

It is important to monitor one or more bonding parameters of interest, relating to bonding structures of a bonded stack, to ensure strict processing requirements are adhered to. For example, one such bonding parameter of interest may be recess height 804 (i.e., the depth of the recess with respect to the surrounding oxide level), also known herein as bonding pad recess height. A pad recess that is too deep may result in cavities within the bond, a recess that is too shallow may result in defects within the bond. Additionally, other parameters related to the shape of the bonding pad and surrounding dielectric may be defined.

For traditional bumps, techniques such as confocal microscopy and white light interferometry are suitable for profilometry. However, these techniques may not be able to accurately measure bonding parameters of interest (or enable measurement at all) having dimensions approaching the optical resolution of those systems, such as the typical pitch of the bonding structures used in hybrid bonding (e.g., smaller than 10$\mu$m, smaller than 5$\mu$m, smaller than 2$\mu$m or smaller than 1$\mu$m).

A through silicon via is another structure used in 2.5D/3D packaging, TSVs. With reference to Figure 9, TSVs 903 are vertical interconnect structures which provide the same function as drilled copper vias in printed circuit board, and as such guide an electronic signal from die 901 to die 902 in the case of vertical die stacking. Top CD 904 and bottom CD 905 in addition to TSV side wall angle (i.e., an angle between a side wall of a via trench structure and a horizontal substrate plane), TSV tilt 906 (i.e., an angular offset of a via with respect to a vertical via), and overlay 908 between the bottom of the via 903 and a corresponding landing pad 907 (i.e., an electrical connection site comprised in e.g., die 902 for electrical connection to via 903) are important profile parameters of TSVs and therefore are each examples of a bonding parameter of interest within the scope of this disclosure. Typically, TSV CD and tilt may be measured using confocal and white light interferometry. However, similar to the hybrid bonding situation, these techniques may not be able to accurately measure TSV parameters of interest having dimensions approaching the optical resolution of those systems.

Thus, it is desirable to provide methods for accurately measuring a parameter of interest (e.g., of a hybrid bonding pad recess or TSV) at length scales beyond the optical resolution of e.g., confocal or white light interferometry.

One such type of profilometry that may measure length scales beyond the optical resolution of confocal and white light interferometry is atomic force microscopy (AFM). AFM is a type of scanning probe microscopy which operates on mechanical principles and is thus not constrained by an optical diffraction limit. In this way AFM may perform measurements with sub-nanometer resolution. One drawback of AFM is that measurements are time consuming. Thus, AFM may not be suitable for process monitoring where throughput is of importance, i.e., high volume manufacturing (HVM).

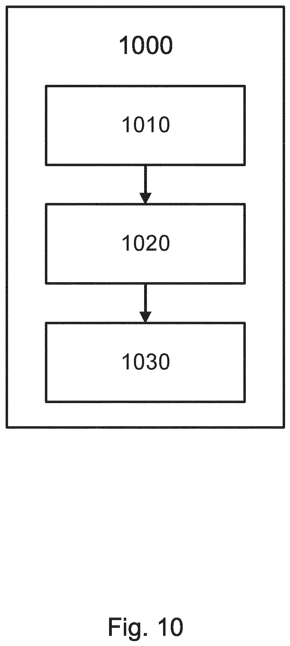

In order to overcome the above-mentioned problems, referring to Figure 10, the inventors have devised a method 1000 of determining at least one bonding parameter of interest relating to a feature on a substrate comprising a step of obtaining 1010 angularly resolved metrology data relating to a measurement of said feature following illumination of said feature with a radiation beam and detecting radiation scattered by said feature at an angularly resolved plain. That is, the feature may be measured using, for example, a metrology tool such as illustrated in Figure 3(a) (using the pupil imaging branch), Figure 3(c), Figure 4, or any other suitable metrology tool. The resulting signals, typically referred to herein as "pupils", each comprise an angularly resolved spectrum of measured values or signal parameter values (e.g., intensities, diffraction efficiencies or any other suitable parameter), in other words angularly resolved metrology data. The angularly resolved metrology data is obtained from radiation scattered from the target on the substrate, and may comprise radiation from any one or more diffraction orders, where a diffraction order in this context includes the zeroth order (specularly reflected radiation). In some examples the radiation is in the optical range. In other examples, the radiation is soft X-ray radiation. In some examples radiation from several wavelengths may be used (e.g., sequential measurements at several wavelengths). The angularly resolved plane may refer to a pupil plane or an image plane of the metrology tool detection system.

The method may further comprise a step of obtaining 1020 at least one trained model being operable to relate said angularly resolved metrology data to said bonding parameter of interest. The trained model may comprise any suitable machine learning model including, for example, a neural network, a support vector machine, or a decision tree that has been trained on suitable data.

For example, the machine learning model may have been trained to a known or observed bonding parameter of interest related to a plurality of training features. The machine learning model may have been trained on such a bonding parameter of interest as measured by a reference tool, for example an AFM, X-SEM, computed X-ray tomography tool or any other tool with sufficient resolution to directly measure the bonding parameter of interest. Angularly resolved training data, i.e., angularly resolved metrology data related to the plurality of training features, across all or part of the feature comprising the bonding parameter of interest may be obtained from the same training features as measured by the reference tool. The angularly resolved training data and corresponding reference tool-based measurements, or reference data may be used together as training input to the machine learning model to obtain the trained model. For example, each angularly resolved training data measurement may be labeled with its corresponding parameter of interest value(s) from the reference data and used to train the machine learning model. The proposed method may further comprise an initial step of performing this training (and all the required metrology) to obtain the trained model.

The machine learning model may be a convolutional neural network CNN. More specifically, the CNN may comprise an input layer, an output layer and hidden layers therebetween. The hidden layers may comprise, for example, a number of repetitions of convolution layers, activation layers, and batch normalization layers, followed by one or more dropout layers and one or more full connection layers.

The method may further comprise a step of using 1030 the trained model to derive the bonding parameter of interest based on the angularly resolved metrology data.

The trained model may be used to determine bonding parameters of interest during process monitoring based on, for example, pupil measurements. That is, because the trained model has been trained on reference data and corresponding angularly resolved training data, the trained model may take, for example, angularly resolved training data as a model input and return a bonding parameter of interest as a model output.

In some examples, the method may further comprise deriving a symmetrical component of the angularly resolved training data and/or deriving an asymmetrical component of the angularly resolved training data, e.g., as an initial processing step prior to inference using the trained model.

Symmetrical angularly resolved training data components may comprise information about the stack or features that are geometrically symmetric, for example CD or stack height which may be known as a symmetrical bonding parameter of interest.

Asymmetrical angularly resolved training data components may comprise information about the stack or features that are geometrically asymmetric, for example TSV tilt, which may be known as an asymmetrical bonding parameter of interest.

IFor example, symmetrical and/or asymmetrical angularly resolved training data components may be derived in accordance with the following relation:

$$P(x) = (P(x) + P(-x))/2 + (P(x) - P(-x))/2 \qquad (1)$$

wherein P(x) is the angularly resolved training data and P(-x) is the angularly resolved training data flipped horizontally,

$$\frac{(P(x) + P(-x))}{2} \qquad (2)$$

corresponds to the symmetric part of the angularly resolved training data, and

$$\frac{(\,P(x) - P(-x)\,)}{2} \qquad (3)$$

corresponds to the asymmetric part of the angularly resolved training data. Note that this is only an example of how such symmetrical and/or asymmetrical components may be obtained, and the skilled person will recognize that many other methods may be used.

Thus, the angularly resolved training data may be processed in such a way as to discard information that is not relevant and retain information pertaining only to the desired bonding parameter of interest. For example, if the bonding parameter of interest is pad recess height, it may be that only the symmetric part of the angularly resolved training data is relevant for the determination of the pad recess height, and therefore only this component used for inference.

Symmetrical and asymmetrical components of the angularly resolved training data may be derived prior to training the machine learning model, e.g., by way of a data processing unit. The individual derived symmetrical and/or asymmetrical components of the angularly resolved training data may serve as training data for the machine learning model. In this way, the machine learning model may be fed data that is relevant to the bonding parameter of interest (i.e., clean data) which may provide more efficient (i.e., faster) model training.

Thus, the machine learning model may be trained on a complete set of angularly resolved training data or individually derived symmetrical and/or asymmetrical components of the angularly resolved training data.

More specifically, the trained model may be trained based on angularly resolved training data that has been unprocessed, i.e., a full data set of angularly resolved training data. The model training may comprise translating said unprocessed angularly resolved metrology data to a bonding parameter of interest based on reference data (i.e., as measured by a reference tool, for example an AFM, X-SEM, computed X-ray tomography tool or any other tool with sufficient resolution to directly measure the bonding parameter of interest). Thus, there may be provided a trained model based on a full data set of angularly resolved training data.

The trained model may be trained based on angularly resolved training data that has been processed, i.e., the training data may comprise symmetrical and/or asymmetrical components derived from said angularly resolved training data. In this case, the model training may comprise translating said symmetrical and/or asymmetrical component training data to a bonding parameter of interest based on reference data (i.e., as measured by a reference tool, for example an AFM, X-SEM, computed X-ray tomography tool or any other tool with sufficient resolution to directly measure the bonding parameter of interest). As such, a single trained model may be used (and therefore initially trained) to infer the bonding parameter from each of the symmetrical and/or asymmetrical components, or a respective different trained model may be used (and therefore initially separately trained) to infer the bonding parameter from each of the symmetrical component and asymmetrical component. Thus, there may be provided a specific symmetrical component trained model and/or a specific asymmetrical component trained model.

In some examples the process may further comprise CD reconstruction. That is, the method may further comprise estimating a diffraction or scattering pattern of said feature and comparing said estimated diffraction pattern to an observed diffraction pattern, wherein said angularly resolved training data may be determined based on the comparison of the estimated diffraction pattern and the observed diffraction pattern.

The angularly resolved training data may comprise synthetic training data. That is, said features may be simulated or modelled, e.g., using simulation software, and simulated measurements thereof may be determined to provide said synthetic training data.

Once the bonding parameter of interest has been derived, it may be possible to determine a correction for forming said feature on one or more further substrates based on said derived bonding parameter of interest. For example, if said bonding parameter of interest relates to bonding pad recess height, and the derived bonding parameter of interest indicates that said bonding pad recess is too shallow, processing parameters related to forming the bonding pad recess on further substrates (e.g., any of chemical mechanical polishing (CMP) time, etch rate and/or etch time) may be adapted based on the determined correction.

While specific embodiments of the invention have been described above, it will be appreciated that the invention may be practiced otherwise than as described.

Further embodiments are disclosed in the subsequent list of numbered clauses:

    1. A method of determining at least one bonding parameter of interest relating to a feature on a substrate comprising:

        obtaining angularly resolved metrology data relating to a measurement of said feature following illumination of said feature with a radiation beam and detecting radiation scattered by said feature at an angularly resolved plane;
        obtaining at least one trained model being operable to relate said angularly resolved metrology data to said bonding parameter of interest; and

using the trained model to derive the bonding parameter of interest based on the angularly resolved metrology data.

2. The method of clause 1, wherein said at least one bonding parameter of interest comprises one or more of: bonding pad recess height, critical dimension of one or both ends of a through silicon via, through silicon via tilt, through silicon via side wall angle, or overlay between a through silicon via and a corresponding landing pad.

3. The method of clause 1 or clause 2, further comprising:

deriving a symmetrical component of the angularly resolved metrology data; and
determining at least one symmetrical bonding parameter of interest from said symmetrical component.

4. The method of clause 3, wherein said at least one symmetrical bonding parameter of interest comprises bonding pad recess height.

5. The method of clause 3, wherein said at least one symmetrical bonding parameter of interest comprises a critical dimension of one or both ends of a through silicon via.

6. The method of any of clauses 3 to 5, wherein said at least one trained model is operable to relate said symmetrical component to said at least one symmetrical bonding parameter of interest.

7. The method of any preceding clause, comprising:

deriving an asymmetrical component of the angularly resolved metrology data; and
determining at least one asymmetrical bonding parameter of interest from said asymmetrical component.

8. The method of clause 7, wherein said at least one asymmetrical bonding parameter of interest comprises one or more of:

through silicon via tilt, through silicon via side wall angle or overlay between a through silicon via and a corresponding landing pad.

9. The method of clause 7 or clause 8, wherein said at least one trained model is operable to relate said asymmetrical component to said at least one asymmetrical bonding parameter of interest.

10. The method of any previous clause, further comprising obtaining angularly resolved training data relating to a plurality of training features;

obtaining reference data relating to the plurality of training features; and
training at least one machine learning model to translate said angularly resolved training data to said reference data to obtain said at least one trained model.

11. The method of clause 10, wherein said method further comprises:

deriving a training symmetrical component of the angularly resolved training data; and
said reference data comprises values for at least one symmetrical bonding parameter of interest.

12. The method of clause 10 or clause 11, wherein said method further comprises:

deriving a training asymmetrical component of the angularly resolved training data; and
said reference data comprises values for at least one asymmetrical bonding parameter of interest.

13. The method of any of clauses 10 to 12, wherein said reference data is obtained by at least one of atomic force microscopy, AFM, scanning electron microscopy, or computed X-ray tomography on said training features.

14. The method of any of clauses 10 to 13, wherein at least a portion of said angularly resolved training data comprises synthetic training data obtained from simulation of said features and simulated measurement thereof.

15. The method of any previous clause, wherein the radiation comprises wavelengths in the optical range and/or wherein the radiation comprises wavelengths in the soft X-ray range.

16. A method as defined in any preceding clause comprising:
determining a correction for forming said feature on one or more further substrates based on the derived bonding parameter of interest.

17. A method as defined in clause 16, comprising
forming said feature on said one or more further substrates using said correction.

18. The method of any preceding clause, further comprising illuminating the feature on a substrate with a radiation beam and detecting angularly resolved radiation scattered by said feature to obtain said angularly resolved metrology data.

19. A computer program comprising program instructions operable to perform the method of any preceding clause, when run on a suitable apparatus.

20. A non-transient computer program carrier comprising the computer program of clause 19.

21. A processing arrangement comprising:

the non-transient computer program carrier of clause 20; and
a processor operable to run the computer program comprised on said non-transient computer program carrier.

22. A metrology apparatus comprising the processing arrangement of clause 21.

23. A lithography cell comprising a lithography apparatus and the metrology apparatus according to clause 22.

Although the techniques and methods are described herein with reference to CD, stack height, recess height and TSV tilt metrology, it is envisioned that the described approaches may be used to determine other bonding parameters of interest, such as dielectric roll-off and topography in general.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

The term target should not be construed to mean only dedicated targets formed for the specific purpose of metrology. The term target should be understood to encompass other structures, including product structures, which have properties suitable for metrology applications.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

**Claims**

1.   A method of determining at least one bonding parameter of interest relating to a feature on a substrate comprising:

obtaining angularly resolved metrology data relating to a measurement of said feature following illumination of said feature with a radiation beam and detecting radiation scattered by said feature at an angularly resolved plane;
obtaining at least one trained model being operable to relate said angularly resolved metrology data to said bonding parameter of interest; and
using the trained model to derive the bonding parameter of interest based on the angularly resolved metrology data.

2.   The method of claim 1, wherein said at least one bonding parameter of interest comprises one or more of: bonding pad recess height, critical dimension of one or both ends of a through silicon via, through silicon via tilt, through silicon via side wall angle, or overlay between a through silicon via and a corresponding landing pad.

3.   The method of claim 1 or claim 2, further comprising:

deriving a symmetrical component of the angularly resolved metrology data; and
determining at least one symmetrical bonding parameter of interest from said symmetrical component.

4.   The method of claim 3, wherein said at least one symmetrical bonding parameter of interest comprises one or more of: bonding pad recess height, or a critical dimension of one or both ends of a through silicon via.

5. The method of claim 3 or claim 4, wherein said at least one trained model is operable to relate said symmetrical component to said at least one symmetrical bonding parameter of interest.

6. The method of any preceding claim, comprising:

   deriving an asymmetrical component of the angularly resolved metrology data; and
   determining at least one asymmetrical bonding parameter of interest from said asymmetrical component.

7. The method of claim 6, wherein said at least one asymmetrical bonding parameter of interest comprises one or more of:
   through silicon via tilt, through silicon via side wall angle or overlay between a through silicon via and a corresponding landing pad.

8. The method of claim 6 or claim 7, wherein said at least one trained model is operable to relate said asymmetrical component to said at least one asymmetrical bonding parameter of interest.

9. The method of any previous claim, further comprising obtaining angularly resolved training data relating to a plurality of training features;

   obtaining reference data relating to the plurality of training features; and
   training at least one machine learning model to translate said angularly resolved training data to said reference data to obtain said at least one trained model.

10. The method of claim 9, wherein said method further comprises:

    deriving a training symmetrical component of the angularly resolved training data; and
    said reference data comprises values for at least one symmetrical bonding parameter of interest.

11. The method of claim 9 or claim 10, wherein said method further comprises:

    deriving a training asymmetrical component of the angularly resolved training data; and
    said reference data comprises values for at least one asymmetrical bonding parameter of interest.

12. The method of any previous claim, wherein the radiation comprises wavelengths in the optical range and/or wherein the radiation comprises wavelengths in the soft X-ray range.

13. A method as claimed in any preceding claim comprising:
    determining a correction for forming said feature on one or more further substrates based on the derived bonding parameter of interest.

14. A computer program comprising program instructions operable to perform the method of any preceding claim, when run on a suitable apparatus.

15. A metrology apparatus comprising a processor operable to run the computer program of claim 14.

Fig. 1

Fig. 2

EP 4 607 576 A1

Fig. 3

19

Fig. 3 (c)

# Fig. 4

# Fig. 5

Fig. 6

```
┌─────────────────────────────────────────────────────┐
│   ┌─────────────────────────────┐                    │
│   │            702              │                    │
│   └─────────────┬───────────────┘                    │
│                 ▼                                     │
│   ┌─────────────────────────────┐                    │
│   │            703              │                    │
│   └─────────────┬───────────────┘                    │
│                 ▼                                     │
│   ┌─────────────────────────────┐                    │
│   │            704              │                    │
│   └─────────────┬───────────────┘◄─────────────────┐ │
│                 ▼                                   │ │
│   ┌─────────────────────────────┐                  │ │
│   │            706              │                  │ │
│   └──────┬───────────────┬──────┘                  │ │
│          │               ▼                         │ │
│          │      ┌──────────────────────────┐       │ │
│          │      │          708             ├───────┘ │
│          │      └──────────────────────────┘         │
│          │                                           │
└──────────┼───────────────────────────────────────────┘
           ▼
   ┌─────────────────────────────┐
   │            710              │
   └─────────────┬───────────────┘
                 ▼
   ┌─────────────────────────────┐
   │            712              │
   └─────────────┬───────────────┘
                 │        ┌ ─ ─ ─ ─ ─ ─ ─ ─ ─ ─ ┐
                 │              716
                 │        └ ─ ─ ─ ─ ─ ─ ─ ─ ─ ─ ┘
                 ▼
   ┌─────────────────────────────┐
   │            714              │
   └─────────────────────────────┘
```

Fig. 7

**804**

801    803    801

**802**

## Fig. 8

**903**    **904**

**908**    **906**

**901**    **901**

**907**    **902**

**905**

## Fig. 9

1000

1010

1020

1030

Fig. 10

Europäisches
Patentamt

European
Patent Office

Office européen
des brevets

# EUROPEAN SEARCH REPORT

**Application Number**

EP 24 15 8686

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2015/330915 A1 (JIN WEN [US] ET AL) 19 November 2015 (2015-11-19) * paragraphs [0027], [0030], [0033], [0036]; claims 1, 4, 5, 6; figures 1, 3 * | 1-15 | INV. H01L21/66 |
| Y | US 2018/350699 A1 (GELLINEAU ANTONIO ARION [US] ET AL) 6 December 2018 (2018-12-06) * paragraphs [0048], [0054], [0081] - [0086], [0130]; claims 1,12; figure 1 * | 1-15 | |
| Y | US 2023/040124 A1 (NIENHUYS HAN-KWANG [NL] ET AL) 9 February 2023 (2023-02-09) * paragraphs [0043], [0051] - [0058], [0206], [0348]; figure 1 * | 3-8,10, 11 | |

TECHNICAL FIELDS
SEARCHED        (IPC)

H01L
G06N
G03F

The present search report has been drawn up for all claims

| Place of search | Date of completion of the search | Examiner |
|---|---|---|
| Munich | 19 August 2024 | Ronnås, Katharina |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 15 8686

This annex lists the patent family members relating to the patent documents cited in  the above-mentioned European search report.
The members are as contained in the European Patent Office EDP file on
The European Patent Office is in no way liable for these particulars which are merely given for the purpose of information.

19-08-2024

| Patent document cited in search report | | Publication date | Patent family member(s) | | Publication date |
|---|---|---|---|---|---|
| US 2015330915 | A1 | 19-11-2015 | NONE | | |
| US 2018350699 | A1 | 06-12-2018 | CN | 110603435 A | 20-12-2019 |
| | | | JP | 7250705 B2 | 03-04-2023 |
| | | | JP | 2020522883 A | 30-07-2020 |
| | | | KR | 20200003256 A | 08-01-2020 |
| | | | KR | 20230098728 A | 04-07-2023 |
| | | | US | 2018350699 A1 | 06-12-2018 |
| | | | US | 2020303265 A1 | 24-09-2020 |
| | | | US | 2021407864 A1 | 30-12-2021 |
| | | | WO | 2018222613 A1 | 06-12-2018 |
| US 2023040124 | A1 | 09-02-2023 | CN | 114902139 A | 12-08-2022 |
| | | | IL | 293749 A | 01-08-2022 |
| | | | KR | 20220103772 A | 22-07-2022 |
| | | | TW | 202138927 A | 16-10-2021 |
| | | | TW | 202227905 A | 16-07-2022 |
| | | | US | 2023040124 A1 | 09-02-2023 |
| | | | WO | 2021121906 A1 | 24-06-2021 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006033921 A1
- US 2010201963 A1
- US 20100328655 A1
- US 2011069292 A1
- US 20110027704 A
- US 20110043791 A
- US 2011102753 A1
- US 20120044470 A
- US 20120123581 A
- US 20130258310 A
- US 20130271740 A
- WO 2013178422 A1
- WO 2017186483 A1
- US 20100214550 A
- US 20070085991 A
- WO 2011081645 A
- US 2006016561 A
- US 2012008127 A
- WO 2015101458 A
- US 2007224518 A
- US 2019003988 A1
- US 2019215940 A1
- US 20170184981 A1
- US 2016282282 A1
- US 20110218789 A1
- US 20110098992 A1

**Non-patent literature cited in the description**

- **LEMAILLET et al.** Intercomparison between optical and X-ray scatterometry measurements of FinFET structures. *Proc. of SPIE*, 2013, 8681